**Europäisches Patentamt**

**European Patent Office**

**Office européen des brevets**

(19)

(11) Veröffentlichungsnummer : **0 351 555 B1**

(12) # EUROPÄISCHE PATENTSCHRIFT

(45) Veröffentlichungstag der Patentschrift :
**03.05.95 Patentblatt 95/18**

(51) Int. Cl.$^6$ : **G03F 7/027**, G03F 7/004

(21) Anmeldenummer : **89110911.8**

(22) Anmeldetag : **16.06.89**

(54) **Durch Strahlung polymerisierbares Aufzeichnungsmaterial und Verfahren zur Herstellung von Reliefaufzeichnungen.**

(30) Priorität : **25.06.88 DE 3821583**

(43) Veröffentlichungstag der Anmeldung :
**24.01.90 Patentblatt 90/04**

(45) Bekanntmachung des Hinweises auf die
Patenterteilung :
**03.05.95 Patentblatt 95/18**

(84) Benannte Vertragsstaaten :
**AT BE CH DE ES FR GB IT LI NL SE**

(56) Entgegenhaltungen :
**EP-A- 0 081 964**
**CHEMICAL ABSTRACTS, Band 99, Nr. 26, Dezember 1983, Seite 639, Zusammenfassung Nr. 222444f, Columbus, Ohio, US ; & SU-A-1 045 214**

(73) Patentinhaber : **MORTON INTERNATIONAL, INC.**
**100 North Riverside Plaza**
**Chicago Illinois 60606-1596 (US)**

(72) Erfinder : **Geissler, Ulrich, Dr.**
**Altenauer Strasse 34**
**D-6203 Hochheim (DE)**
Erfinder : **Wilski, Hans, Dr.**
**Händelstrasse 18**
**D-6232 Bad Soden (DE)**

(74) Vertreter : **Weber, Dieter, Dr. et al**
**Weber, Dieter, Dr.,**
**Seiffert, Klaus, Dipl.-Phys.,**
**Lieke, Winfried, Dr.**
**Postfach 61 45**
**D-65051 Wiesbaden (DE)**

## Beschreibung

Die Erfindung betrifft ein durch Strahlung polymerisierbares Aufzeichnungsmaterial mit einem flexiblen transparenten temporären Schichtträger, einer übertragbaren thermoplastischen, durch Strahlung polymerisierbaren Photoresistschicht, die als wesentliche Bestandteile

a) ein polymeres wasserunlösliches, in wäßrig-alkalischen Lösungen lösliches Bindemittel,

b) eine radikalisch polymerisierbare ethylenisch ungesättigte Verbindung mit einem Siedepunkt oberhalb 100 °C bei Normaldruck und

c) eine Verbindung oder eine Verbindungskombination enthält, die unter Einwirkung aktinischer Strahlung die Polymerisation der Verbindung b) zu initiieren vermag,

und einem abziehbaren Deckblatt auf der freien Seite der Photoresistschicht, das an dieser Schicht weniger stark haftet als der temporäre Schichtträger.

Das Material ist insbesondere zur Herstellung von Photoresists nach dem Trockenresistverfahren aeeignet.

Photopolymerisierbare Aufzeichnungsmaterialien der genannten Gattung sind bekannt. Ein kritischer Schritt bei der Verarbeitung nach dem Trockenresistverfahren ist das Laminieren der photopolymerisierbaren Schicht auf den permanenten Schichtträger mit einer oberfläche aus Kupfer oder einer Kupferlegierung. Hier ist es schwierig, unter den erforderlichen Verarbeitungsbedingungen eine in allen Fällen gleich gute Haftung der Schicht auf dem Kupfer zu erreichen.

So wird in der Leiterplattentechnik häufig mit handelsüblichen Laminatoren gearbeitet, deren Walzen aufgrund sehr langer Betriebszeiten über die Walzenbreite mit sehr unterschiedlichem Anpreßdruck arbeiten, eine mangelhafte Justierung aufweisen, ungleichmäßig beheizt und teilweise sogar oberflächlich beschädigt sind. Ferner ist in vielen Fällen nicht immer gewährleistet, daß die häufig empfohlene Vorwärmung der zu laminierenden Platinen auch tatsächlich durchgeführt wird.

Solche Schwankungen in den Verarbeitungsbedingungen können auch bei einem an sich gut haftenden Resist erhebliche Verarbeitungsfehler nach sich ziehen, z. B.:

- Vollflächiges Abheben der Laminate
- Ausrisse beim Beschnitt laminierter Platten
- Entwicklungsfehler
- Unterwanderung beim Galvanisieren
- Mangelnde Beständigkeit beim Ätzen.

Zur Verbesserung der Haftung, insbesondere auf Kupfer, sind schon zahlreiche Maßnahmen oder Zusätze zur Photoresistschicht vorgeschlagen worden.

In den US-A 3 622 334 und 3 645 772 wird die Verwendung heterocyclischer Stickstoffverbindungen zur Verbesserung der Haftung von Trockenresistschichten beschrieben.

In den DE-C 24 48 821 und 24 48 850 wird die Verwendung von Mercaptoalkansäurederivaten für den gleichen Zweck beschrieben.

Die vorstehend genannten Verbindungen bewirken im wesentlichen eine Verbesserung der Haftung der belichteten Schichten. Sie haben damit in erster Linie eine erhöhte Resistenz der gehärteten Schicht gegenüber Verarbeitungschemikalien, insbesondere galvanischen Bädern, zur Folge.

Die DE-B 23 27 513 beschreibt auch als Trockenresist geeignete photopolymerisierbare Gemische auf Basis von ethylenisch ungesättigten, polymerisierbaren Verbindungen, einem Hexaaryl-bisimidazol als Photoinitiator und einer als Wasserstoffdonator wirksamen cyclischen Dicarbonylverbindung. Als Haftvermittler werden dort ebenfalls die oben erwähnten heterocyclischen Stickstoffverbindungen genannt. Die Gemische können außerdem Weichmacher, z. B. Dicarbonsäureester, Alkyl- und Arylphosphate, Glykolester, Polyoxyalkylenglykole, aliphatische Polyole und verschiedene andere Verbindungsklassen, enthalten, wobei in den Beispielen praktisch nur Trikresylphosphat eingesetzt wird.

In der US-A 3 046 127 werden photopolymerisierbare Gemische beschrieben, die insbesondere für Hochdruckplatten eingesetzt werden. Sie haben entweder keinen Schichtträger oder solche aus Stahl, Aluminium oder Kunststoffolien. Die Gemische enthalten als Photoinitiatoren Mehrkernchinone und als Kettenüberträger Ether, Thioether, Mercaptane, Etheralkohole, z. B. Polyglykole, oder mehrwertige Alkohole.

Die EP-A-0 081 964 betrifft ein durch Strahlung polymerisierbares Gemisch eines teilverseiften Polyvinylacetats, eines bifunktionellen Acrylats, von Dimethylbenzylacetat und eines Diethylenglykols.

Aufgabe der Erfindung war es, die Haftung von unbelichteten Trockenphotoresistschichten gegenüber Kupferoberflächen zuverlässig zu verbessern, ohne daß andere wesentliche Eigenschaften des Materials beeinträchtigt werden.

Erfindungsgemäß wird diese Aufgabe mit einem durch Strahlung polymerisierbaren Aufzeichnungsmaterial mit den eingangs genannten Merkmalen gelöst, das dadurch gekennzeichnet ist, daß die

EP 0 351 555 B1

Photoresistschicht ferner ein aliphatisches Polyol mit 2 bis 15 Hydroxygruppen enthält.

Erfindungsgemäß wird auch ein Verfahren zur Herstellung von Reliefaufzeichnungen vorgeschlagen, bei dem man eine trockene, feste, durch Strahlung polymerisierbare Photoresistschicht, die als wesentliche Bestandteile

a) ein polymeres Bindemittel,

b) eine radikalisch polymerisierbare ethylenisch ungesättigte Verbindung mit einem Siedepunkt oberhalb 100 °C bei Normaldruck und

c) eine Verbindung oder eine Verbindungskombination enthält, die unter Einwirkung aktinischer Strahlung die Polymerisation der Verbindung b) zu initiieren vermag,

enthält und die sich auf einem flexiblen transparenten temporären Schichtträger befindet, unter Druck und Erwärmen auf einen endgültigen Schichtträger laminiert, dessen Oberfläche aus Kupfer oder einer Kupferlegierung besteht, die Schicht bildmäßig bestrahlt, den temporären Schichtträger abzieht und die unbestrahlten Schichtbereiche mit einem Entwickler auswäscht.

Das erfindungsgemäße Verfahren ist dadurch gekennzeichnet, daß die Photoresistschicht ferner ein aliphatisches Polyol mit 2 bis 15 Hydroxygruppen enthält.

Das in der durch Strahlung polymerisierbaren, insbesondere photopolymerisierbaren Schicht enthaltene Polyol hat vorzugsweise 2 bis 5, insbesondere 2 oder 3 Hydroxyguppen. Die Verbindung kann monomer, oligomer oder polymer sein. Als Oligomere und Polymere kommen insbesondere Polyalkylendiole, z. B. Polyethylenglykole oder Polypropylenglykole, in Betracht. Die Molekulargewichte dieser polymeren Polyole sind vorzugsweise nicht größer als 800, insbesondere nicht größer als 600. Beispiele für geeignete Polyole sind Ethylenglykol, Propylenglykol, Butandiol-1,4, Triethylenglykol, Dipropylenglykol, Butandiol-1,2, Glycerin, Trimethylolethan, Trimethylolpropan, Pentaerythrit, Dipentaerythrit sowie die Umsetzungsprodukte solcher Polyole mit Ethylenoxid oder Propylenoxid.

Der Mengenanteil an Polyol in der photopolymerisierbaren Schicht beträgt im allgemeinen 0,1 bis 5, vorzugsweise 0,3 bis 3 Gew.-%, bezogen auf die nichtflüchtigen Schichtbestandteile.

Die erfindungsgemäßen Materialien enthalten polymerisierbare Verbindungen mit mindestens einer endständigen ethylenischen Doppelbindung. Als polymerisierbare Verbindungen werden im allgemeinen Ester der Acryl- oder Methacrylsäure mit ein- oder mehrwertigen, vorzugsweise primären, Alkoholen verwendet. Vorzugsweise sollten mindestens 20 % der Gesamtmenge an polymerisierbaren Verbindungen mehr als eine, insbesondere 2 bis 4, polymerisierbare Gruppen enthalten. Beispiele für geeignete mehrwertige Alkohole sind Ethylenglykol, Propylenglykol, Butandiol-1,4, Butandiol-1,3, Diethylenglykol, Triethylenglykol oder Polypropylenglykole mit Molekulargewichten von etwa 200 bis 1.000, Neopentylglykol, Glycerin, Trimethylolethan und -propan, Pentaerythrit, Bisphenol-A-Derivate sowie Umsetzungsprodukte dieser Verbindungen mit Ethylenoxid und/oder Propylenoxid. Besonders geeignet sind Urethangruppen enthaltende Bisacrylate und Bismethacrylate, die durch Umsetzung von 1 mol eines Diisocyanats mit 2 mol Hydroxyalkylacrylat oder -methacrylat erhalten werden. Das Diisocyanat kann auch ein oligomeres, durch Umsetzen eines Diols mit einem molaren Überschuß an monomerem Diisocyanat erhaltenes Produkt sein. Derartige und ähnliche Urethangruppen enthaltende Monomere sind in den DE-A 20 64 079, 28 22 190, 30 48 502 und 35 40 480 beschrieben. Vorzugsweise sollte das Gemisch mindestens 40 %, insbesondere mindestens 60 %, bezogen auf den Gesamtmonomerengehalt, an Monomeren mit mindestens einer Urethangruppe im Molekül enthalten.

Soweit einfach ungesättigte polymerisierbare Verbindungen eingesetzt werden, sind dies vorzugsweise Acryl- oder Methacrylsäureester oder -amide von aliphatischen Alkoholen oder Aminen mit mindestens einer Urethan- oder Harnstoffgruppe und mindestens einer Alkylenoxygruppe im Molekül. Besonders bevorzugt werden die in der EP-A 222 320 beschriebenen Verbindungen, z. B. Umsetzungsprodukte von Hydroxyethylacrylat mit Caprolacton und einem Alkylisocyanat.

Die Gesamtmenge an polymerisierbaren Verbindungen in dem erfindungsgemäßen Gemisch beträgt im allgemeinen 25 bis 75, vorzugsweise 40 bis 60 Gew.-% bezogen auf die nichtflüchtigen Bestandteile des Gemischs.

Als durch Strahlung, insbesondere aktinisches Licht aktivierbare Polymerisationsinitiatoren in dem erfindungsgemäßen Gemisch können eine Vielzahl von Substanzen Verwendung finden. Beispiele sind Benzoin und seine Derivate, Trichlormethyl-s-triazine, Trihalogenmethylgruppen enthaltende Carbonylmethylenheterocyclen, z. B. 2-(p-Trichlormethyl-benzoylmethylen)-3-ethylbenzthiazolin, Acridinderivate, z. B. 9-Phenyl-acridin, 9-p-Methoxy-phenyl-acridin, 9-Acetylamino-acridin, Benz(a)acridin; Phenazinderivate, z. B. 9,10-Dimethylbenz(a)phenazin, 10-Methoxy-benz(a)phenazin, Chinoxalinderivate, z. B. 6,4′,4″-Trimethoxy-2,3-diphenylchinoxalin, 4′,4″-Dimethoxy-2,3-diphenyl-5-azachinoxalin oder Chinazolinderivate. Die Initiatoren werden allgemein in einer Menge von 0,01 bis 10, vorzugsweise von 0,05 bis 4 Gew.-%, bezogen auf die nicht flüchtigen Bestandteile des Gemisches, eingesetzt.

Als Bindemittel können eine Vielzahl löslicher organischer Polymerisate Einsatz finden. Als Beispiele seien

3

genannt: Polyamide, Polyvinylester, Polyvinylacetale, Polyvinylether, Epoxidharze, Polyacrylsäureester, Polymethacrylsäureester, Polyester, Alkydharze, Polyacrylamid, Polyvinylalkohol, Polyethylenoxid, Polydimethylacrylamid, Polyvinylpyrrolidon, Polyvinylmethylformamid, Polyvinylmethylacetamid sowie Mischpolymerisate der Monomeren, die die aufgezählten Homopolymerisate bilden.

Erfindungsgemäß werden Bindemittel verwendet, die wasserunlöslich, aber in wäßrig-alkalischen Lösungen löslich oder mindestens quellbar sind, da sich Schichten mit solchen Bindemitteln mit den bevorzugten wäßrigalkalischen Entwicklern entwickeln lassen. Derartige Bindemittel können z. B. die folgenden Gruppen enthalten: -COOH, $-PO_3H_2$, $-SO_3H$; $-SO_2NH-$, $-SO_2-NH-SO_2-$ und $-SO_2-NH-CO-$.

Als Beispiele hierfür seien genannt: Maleinatharze, Polymerisate aus N-(p-Tolyl-sulfonyl)-carbaminsäure-β-(methacryloyloxy)-ethylester und Mischpolymerisate dieser und ähnlicher Monomerer mit anderen Monomeren sowie Styrol-Maleinsäureanhydrid-Mischpolymerisate. Alkylmethacrylat-Methacrylsäure-Mischpolymerisate und Mischpolymerisate aus Methacrylsäure, Alkylmethacrylaten und Methylmethacrylat und/oder Styrol, Acrylnitril u. a., wie sie in den DE-A 20 64 080 und 23 63 806 beschrieben sind, werden bevorzugt. Besonders bevorzugt werden höhermolekulare Mischpolymerisate, wie sie in der DE-A 34 27 519 beschrieben sind.

Die Menge des Bindemittels beträgt im allgemeinen 25 bis 75, vorzugsweise 40 bis 60 Gew.-% der Bestandteile des Gemischs.

Das Gemisch kann als übliche weitere Bestandteile Polymerisationsinhibitoren, Wasserstoffdonatoren, sensitometrische Regler, Farbstoffe, Pigmente, Weichmacher und thermisch aktivierbare Vernetzungsmittel enthalten.

Als aktinische Strahlung, gegenüber der das erfindungsgemäße Gemisch empfindlich ist, kommt jede elektromagnetische Strahlung in Betracht, deren Energie zur Auslösung einer Polymerisation ausreicht. Geeignet sind insbesondere sichtbares und ultraviolettes Licht, Röntgen- und Elektronenstrahlung. Auch Laserstrahlung im sichtbaren und UV-Bereich kann verwendet werden. Bevorzugt wird kurzwelliges sichtbares und nahes UV-Licht.

Als Schichtträger für mit dem erfindungsgemäßen Gemisch hergestellte Aufzeichnungsmaterialien sind insbesondere Kunststoffolien, z. B. aus Polyethylenterephthalat, geeignet. Die Trägeroberfläche kann chemisch oder mechanisch vorbehandelt werden, um die Haftung der Schicht richtig einzustellen.

Das erfindungsgemäße Gemisch findet bevorzugt Anwendung als trocken übertragbares Photoresistmaterial. Dazu kann es in bekannter Weise als vorgefertigte, übertragbare Trockenresistfolie auf das zu bearbeitende Werkstück, z. B. auf Leiterplatten-Basismaterial, aufgebracht werden, dessen Oberfläche aus Kupfer oder einer Kupferlegierung besteht. Im allgemeinen wird zur Herstellung des Trockenresistmaterials eine Lösung des Gemisches in einem Lösemittel auf einen geeigneten Schichtträger, z. B. eine Polyesterfolie, aufgebracht und getrocknet. Die Schichtdicke der Resistschicht kann etwa 10 bis 80, vorzugsweise 20 bis 60 μm betragen. Die freie Oberfläche der Schicht wird vorzugsweise mit einer Deckfolie, z. B. aus Polyethylen oder Polypropylen, abgedeckt.

Die Folien lassen sich mit in der Trockenresisttechnik üblichen Geräten verarbeiten. In einer handelsüblichen Laminiervorrichtung wird die Deckfolie abgezogen und die Photoresistschicht auf kupferkaschiertes Basismaterial auflaminiert. Die so präparierte Platte wird dann durch eine Vorlage belichtet und nach Abziehen der Trägerfolie in bekannter Weise entwickelt.

Als Entwickler sind z. B. wäßrige, vorzugsweise wäßrig-alkalische Lösungen, z. B. von Alkaliphosphaten, -hydroxiden, -carbonaten oder -silikaten, geeignet, denen gegebenenfalls kleine Mengen, z. B. bis zu 10 Gew.-% an mit Wasser mischbaren organischen Lösemitteln oder Netzmitteln zugesetzt werden können. Wenn Bindemittel eingesetzt werden, die in wäßrig-alkalischen Lösungen nicht löslich sind, werden auch organische Lösemittel, z. B. Trichlorethan, verwendet.

Die erfindungsgemäßen Gemische lassen sich für die verschiedensten Anwendungsgebiete einsetzen. Mit besonderem Vorteil werden sie in Form eines Trockenresistfilms zur Herstellung von Reservagen, d. h. Ätzschutzschichten oder Galvanoreserven, auf Trägern aus Kupfer verwendet.

Die auf Kupfer laminierte photopolymerisierbare Schicht hat eine so feste Haftung und Kohäsion, daß die freitragenden, die Löcher überdeckenden Schichtbereiche beim Abtrennen der Trägerfolie unbeschädigt bleiben und nicht von dieser Folie mitgerissen werden.

Im Vergleich zu bekannten Trockenresistschichten haben die erfindungsgemäßen Schichten den Vorteil einer besseren Haftung auf Kupfer und einer geringeren Sprödigkeit.

Die folgenden Beispiele erläutern bevorzugte Ausführungsformen des erfindungsgemäßen Aufzeichnungsmaterials und ihre Anwendung. Wenn nichts anderes angegeben ist, sind Prozentzahlen und Mengenverhältnisse in Gewichtseinheiten zu verstehen. Gewichtsteile (GT) und Volumenteile (VT) stehen im Verhältnis von g zu $cm^3$.

Beispiele 1 bis 10

Die folgenden Beschichtungslösungen wurden hergestellt:

5,3 GT    eines Terpolymerisats aus Methylmethacrylat, n-Hexylmethacrylat und Methacrylsäure (5 : 60 : 35) mit dem mittleren Molekulargewicht $M_w$ = 70.000,

1,4 GT    eines Diurethans aus 2 mol Hydroxyethylmethacrylat und 1 mol 2,2,4-Trimethylhexamethylendiisocyanat,

3,3 GT    des Umsetzungsprodukts aus 1 mol Hydroxyethylacrylat, 2 mol Caprolacton und 1 mol n-Butylisocyanat,

0,05 GT    9-Phenyl-acridin,

0,01 GT    eines blauen Azofarbstoffs, erhalten durch Kuppeln von 2,4-Dinitro-6-chlor-benzoldiazoniumsalz mit 2-Methoxy-5-acetylamino-N,N-diethylanilin, und

0,1 GT    einer der unten angegebenen Verbindungen in

16 GT    Butanon und

4 GT    Ethanol

Folgende Verbindungen wurden im einzelnen eingesetzt:

1) Ethylenglykol

2) Triethylenglykol

3) Polyethylenglykol 400

4) Dipropylenglykol

5) Trimethylolpropan

6) Bis-Trimethylolpropan (Bis-(2,2-dimethylolbutyl)ether)

7) Pluracol PEP 450 (Umsetzungsprodukt von Pentaerythrit mit Propylenoxid, OH-Zahl: 552)

8) Glycerin

9) ohne Zusatz (Vergleich)

10) Trikresylphosphat (Disflamoll TKP, Bayer AG; Vergleich)

Die Lösungen wurden auf biaxial verstreckte und thermofixierte Polyethylenterephthalatfolien von 25 μm Dicke so aufgeschleudert, daß nach dem Trocknen bei 100 °C jeweils ein Schichtgewicht von 45 g/m² erhalten wurde.

Die so hergestellten Trockenresistfolien wurden mit einer handelsüblichen Laminiervorrichtung bei 115 °C auf mit 35 μm starker Kupferfolie kaschierte Phenoplast-Schichtstoffplatten laminiert. Die Laminiervorrichtung stand dabei in einem mit Gelblicht beleuchteten Raum bei 22 °C und 40 % relativer Luftfeuchtigkeit. Vor dem Laminieren wurden die Proben 5 Stunden in diesem Raum gelagert.

Die Haftung der Resistschichten auf Kupfer wurde sofort nach dem Laminieren und nach einer Haltezeit von 15 Minuten nach DIN 53232 wie folgt geprüft. Mit einem kammartigen Gitterschnittwerkzeug wurden parallele Schnitte von 1 mm Abstand in einer Richtung und in einer zweiten um 90 ° dazu geänderten Richtung durch die Resistschicht hindurch eingeritzt. Dann wurde ein druckempfindlicher Klebestreifen auf die Schichtoberfläche im Schnittbereich fest aufgedrückt und mit definierter Kraft und Geschwindigkeit abgezogen. Die Haftung der Schichten wurde danach bewertet, wie die Schnittkanten aus sahen und wieviel Prozent der Schnittquadrate vom Schichtträger abgelöst waren. Die Bewertung erfolgte auf einer Skala von Gt 0 bis Gt 4, wobei Gt 0 vollständig glatte, unbeschädigte Schnittkanten und 0 % Ablösung, Gt 4 starke streifenweise Absplitterung entlang der Schnittquadrate und 65 % Ablösung bedeutet. (Gt steht hier für "Güte").

Die folgende Tabelle zeigt die Ergebnisse:

| Beispiel | 1 | 2 | 3 | 4 | 5 | 6 | 7 | 8 | 9 | 10 |
|---|---|---|---|---|---|---|---|---|---|---|
| Haftung | | | | | | | | | | |
| ohne Haltezeit | Gt3 | Gt0 | Gt0 | Gt1 | Gt0 | Gt2 | Gt3 | Gt0 | Gt4 | Gt4 |
| nach 15 min | Gt2 | Gt0 | Gt0 | Gt0 | Gt0 | Gt0 | Gt1 | Gt0 | Gt4 | Gt4 |

Eine weitere Haftungsprüfung wurde wie folgt durchgeführt:

Auf eine mit 35 μm starker Kupferfolie kaschierte Phenoplast-Schichtstoffplatte (10 cm x 15 cm) wurden jeweils 2 Resiststreifen der Größe 15 cm x 5 cm so auflaminiert, daß an 4 Positionen ein Resistüberstand von 2,5 x 5 cm gegeben war (siehe Skizze):

← 5 cm →

```
          a                  c              ↘ Resist

                                           kupferkaschierte
                                           Phenoplast-
                                           Schichtstoffplatte

          b                  d
```

15 cm | 10 cm

← 15 cm →

Der überstehende Resist incl. Polyesterfolie wurde 1 Minute nach dem Laminieren an den 4 mit a, b, c und d bezeichneten Positionen im rechten Winkel von der Basismaterialkante manuell abgezogen.

Ein Maß für die Kupferhaftung ist die freigelegte Kupferoberfläche in %, bezogen auf die auflaminierte Resistfläche (2 x 10 cm x 5 cm).

| Beispiel | 8 | 9 | 10 |
|---|---|---|---|
| freigelegte Resistfläche (%) | 4 | 100 | 100 |

Man erkennt die deutliche Haftungsverbesserung durch die Zusätze gemäß der Erfindung.

Die laminierten Platten wurden mittels einer 5-kW-Metall-halogenidlampe im Abstand von 110 cm zwischen Lampe und Vakuumkopierrahmen 5 s belichtet. Als Vorlage diente eine Strichvorlage mit Linienbreiten und Abständen bis herab zu 80 µm.

Nach der Belichtung wurden die Polyesterfolien abgezogen und die Schichten mit 1 %iger Natriumcarbonatlösung in einem Sprühentwicklungsgerät innerhalb 60 s entwickelt. Die entwickelten Platten wurden 30 s mit Leitungswasser gespült, 30 s in einer 15 %igen Ammoniumperoxydisulfat-Lösung angeätzt, erneut mit Wasser gespült, 30 s in 10 %ige Schwefelsäure getaucht und sodann nacheinander in den folgenden Elektrolytbädern galvanisiert:

1. 60 Minuten in einem Kupferelektrolytbad der Firma Schlötter, Geislingen/Steige, Typ "Glanzkupfer-Bad"
Stromdichte:    2,5 A/dm²
Metallaufbau:   ca. 30 µm
Temperatur:     Raumtemperatur
2. 15 Minuten in einem Blei-Zinnbad LA der Firma Schlötter, Geislingen/Steige,
Stromdichte:    2 A/dm²
Metallaufbau:   15 µm
Temperatur:     Raumtemperatur

Die Platten der Beispiele 1 bis 8 zeigten keinerlei Unterwanderungen oder Beschädigungen, auf den Vergleichsplatten 9 und 10 wurden hingegen Unterwanderungen festgestellt.

Vergleichsbeispiel für Flüssigresist

Die in den Beispielen 8, 9 und 10 angegebenen Beschichtungslösungen wurden nach Verdünnen mit einem Gemisch aus Butanon und Ethanol (16 :4) auf mit 35 μm starker Kupferfolie kaschierte Phenoplast-Schichtstoffplatten so aufgeschleudert, daß nach dem Trocknen bei 100 °C jeweils ein Schichtgewicht von 17 g/m² erhalten wurde.

Die Prüfung der Kupferhaftung erfolgte wie in Beispiel 1 beschrieben und lieferte folgende Ergebnisse:

```
Lösung aus Beispiel        8        9        1 0
Haftung                   Gt 0    Gt 0     Gt 0
```

Es ergibt sich somit, daß bei Anwendung als Trockenresist die Kupferhaftung durch Zusatz geringer Mengen eines Polyols verbessert wird.

Bei Anwendung als Flüssigresist, d. h. bei direktem Beschichten der Kupferoberfläche, wird dagegen kein Unterschied beobachtet.

**Patentansprüche**

1. Durch Strahlung polymerisierbares Aufzeichnungsmaterial mit einem flexiblen transparenten temporären Schichtträger, einer übertragbaren thermoplastischen, durch Strahlung polymerisierbaren Photoresistschicht, die als wesentliche Bestandteile

   a) ein polymeres wasserunlösliches, in wäßrig-alkalischen Lösungen lösliches Bindemittel,

   b) eine radikalisch polymerisierbare ethylenisch ungesättigte Verbindung mit einem Siedepunkt oberhalb 100 °C bei Normaldruck und

   c) eine Verbindung oder eine Verbindungskombination enthält, die unter Einwirkung aktinischer Strahlung die Polymerisation der Verbindung b) zu initiieren vermag,

   und einem abziehbaren Deckblatt auf der freien Seite der Photoresistschicht, das an dieser Schicht weniger stark haftet als der temporäre Schichtträger, dadurch gekennzeichnet. daß die Photoresistschicht ferner ein aliphatisches Polyol mit 2 bis 15 Hydroxygruppen enthält.

2. Aufzeichnungsmaterial nach Anspruch 1, dadurch gekennzeichnet, daß es 0,1 bis 5 Gew.-% aliphatisches Polyol, bezogen auf die nichtflüchtigen Bestandteile der Schicht, enthält.

3. Aufzeichnungsmaterial nach Anspruch 1, dadurch gekennzeichnet, daß das Polyol 2 oder 3 Hydroxygruppen aufweist.

4. Aufzeichnungsmaterial nach Anspruch 1, dadurch gekennzeichnet, daß die radikalisch polymerisierbare Verbindung mindestens zwei ethylenisch ungesättigte polymerisierbare Gruppen aufweist.

5. Aufzeichnungsmaterial nach Anspruch 1, dadurch gekennzeichnet, daß die Photoresistschicht 25 bis 75 Gew.-% an polymerem Bindemittel, 25 bis 75 Gew.-% an radikalisch polymerisierbaren Verbindungen und 0,01 bis 10 Gew.-% an Initiatoren bzw. Initiatorkombinationen, bezogen auf die Gesamtmenge an nichtflüchtigen Bestandteilen, enthält.

6. Verfahren zur Herstellung von Reliefaufzeichnungen, bei dem man eine trockene, feste, durch Strahlung polymerisierbare Photoresistschicht, die als wesentliche Bestandteile

   a) ein polymeres Bindemittel,

   b) eine radikalisch polymerisierbare ethylenisch ungesättigte Verbindung mit einem Siedepunkt oberhalb 100 °C bei Normaldruck und

   c) eine Verbindung oder eine Verbindungskombination enthält, die unter Einwirkung aktinischer Strahlung die Polymerisation der Verbindung b) zu initiieren vermag,

   und die sich auf einem flexiblen transparenten temporären Schichtträger befindet, unter Druck und Erwärmen auf einen endgültigen Schichtträger laminiert, dessen Oberfläche aus Kupfer oder einer Kupferlegierung besteht, die Schicht bildmäßig bestrahlt, den temporären Schichtträger abzieht und die unbestrahlten Schichtbereiche mit einem Entwickler auswäscht, dadurch gekennzeichnet, daß die Photoresistschicht ferner ein aliphatisches Polyol mit 2 bis 15 Hydroxygruppen enthält.

## Claims

1. A recording material which is polymerisable by radiation, with a flexible, transparent, temporary layer carrier, a transferrable, thermoplastic, radiation-polymerisable photoresist layer, which contains as essential components
   a) a polymeric bonding agent which is insoluble in water and soluble in aqueous alkaline solutions,
   b) a radical-polymerisable ethylenically unsaturated compound with a boiling point above 100° C at normal pressure and
   c) a compound or a compound combination, which under the action of actinic radiation is able to initiate the polymerisation of compound b)
   and with a removable cover sheet on the free side of the photoresist layer, which adheres less strongly to this layer than the temporary layer carrier does, characterised in that the photoresist layer additionally contains an aliphatic polyol with 2 to 15 hydroxy groups.

2. A recording material according to Claim 1, characterised in that it contains 0.1 to 5 % by weight aliphatic polyol, in relation to the non-volatile components of the layer.

3. A recording material according to Claim 1, characterised in that the polyol has 2 or 3 hydroxy groups.

4. A recording material according to Claim 1, characterised in that the radical-polymerisable compound has at least two ethylenically unsaturated polymerisable groups.

5. A recording material according to Claim 1, characterised in that the photoresist layer contains 25 to 75 % by weight polymeric bonding agent, 25 to 75 % by weight radical-polymerisable compounds and 0.01 to 10 % by weight initiators or initiator combinations, in relation to the total amount of non-volatile components.

6. A method for the production of relief recordings, in which a dry, solid, radiation-polymerisable photoresist layer, which contains as essential components
   a) a polymeric bonding agent,
   b) a radical-polymerisable ethylenically unsaturated compound with a boiling point above 100° C at normal pressure and
   c) a compound or a compound combination, which under the action of actinic radiation is able to initiate the polymerisation of compound b),
   and which is situated on a flexible, transparent, temporary layer carrier, is laminated under pressure and heating onto a final layer carrier, the surface of which consists of copper or a copper alloy, the layer is irradiated in accordance with an image, the temporary layer carrier is removed and the non-irradiated layer regions are washed out with a developer, characterised in that the photoresist layer additionally contains an aliphatic polyol with 2 to 15 hydroxy groups.

## Revendications

1. Matériau d'enregistrement polymérisable par irradiation qui possède un support de couche temporaire transparent souple, une couche photosensible polymérisable par irradiation thermoplastique et transférable, qui comprend comme composants essentiels
   a) un liant polymère insoluble dans l'eau, soluble dans les solutions aqueuses alcalines,
   b) un composé éthyléniquement insaturé polymérisable par voie radicalaire ayant un point d'ébullition supérieur à 100°C à pression atmosphérique, et
   c) un composé ou une combinaison de composés qui sous l'effet d'une irradiation actinique permet d'initier la polymérisation du composé b),
   et une feuille de couverture amovible sur la face libre de la couche photosensible, qui adhère sur cette couche moins fortement que le support temporaire, caractérisé en ce que la couche photosensible contient en outre un polyol aliphatique ayant 2 à 15 groupes hydroxy.

2. Matériau d'enregistrement selon la revendication 1, caractérisé en ce qu'il contient 0,1 à 5 % en poids de polyol aliphatique, par rapport aux composants non volatils de la couche.

3. Matériau d'enregistrement selon la revendication 1, caractérisé en ce que le polyol contient 2 ou 3 groupes hydroxy.

4. Matériau d'enregistrement selon la revendication 1, caractérisé en ce que le composé polymérisable par voie radicalaire présente au moins deux groupes polymérisables éthyléniquement insaturés.

5. Matériau d'enregistrement selon la revendication 1, caractérisé en ce que la couche photosensible contient 25 à 75 % en poids d'un liant polymère, 25 à 75 % en poids de composés polymérisables par voie radicalaire et 0,01 à 10 % en poids d'initiateurs ou de combinaisons d'initiateurs, par rapport à la quantité totale de composants non volatils.

6. Procédé de production d'enregistrement en relief, dans lequel on utilise une couche photosensible solide, sèche, polymérisable par irradiation, qui contient comme composants essentiels
   a) un liant polymère
   b) un composé éthyléniquement insaturé polymérisable par voie radicalaire ayant un point d'ébullition supérieur à 100°C à la pression atmosphérique, et
   c) un composé ou une combinaison de composés, qui permet d'initier la polymérisation du composé b) sous l'effet d'une irradiation actinique,
et qui se trouve sur un support de couche temporaire transparent souple, qu'on stratifie sous pression et chauffage sur un support de couche définitif, dont la surface est constituée de cuivre ou d'un alliage de cuivre, on irradie la couche pour former des motifs, on retire le support de couche temporaire et on rince les domaines de couches non exposés avec un développateur, caractérisé en ce que la couche photosensible contient en outre un polyol aliphatique de 2 à 15 groupes hydroxy.